# EUROPÄISCHE PATENTSCHRIFT

(11) **EP 4 042 454 B1**
(45) Veröffentlichungstag und Bekanntmachung des Hinweises auf die Patenterteilung: **04.09.2024**
(21) Anmeldenummer: 20771241.5
(22) Anmeldetag: 07.09.2020
(51) Int. Cl.: H01F 17/06, H01F 27/02, H01F 27/26

(54) **EINRICHTUNG ZUM ABSORBIEREN VON ELEKTRISCHEM RAUSCHEN AUF LEITUNGEN UND VERFAHREN ZUM ANORDNEN EINER SOLCHEN EINRICHTUNG**
DEVICE FOR ABSORBING ELECTRIC NOISE ON CABLES AND METHOD TO INSTALL SUCH A DEVICE
DISPOSITIF POUR ABSORBER LE BRUIT ÉLECTRIQUE SUR LES CÂBLES ET PROCÉDÉ POUR INSTALLER UN TEL DISPOSITIF

(30) Priorität: 11.10.2019 DE 102019215619
(43) Veröffentlichungstag der Anmeldung: 17.08.2022
(73) Patentinhaber: Würth Elektronik eiSos GmbH & Co. KG, 74638 Waldenburg (DE)
(72) Erfinder: AUPKE, Klaus, 48282 Emsdetten (DE)
(74) Vertreter: Patentanwälte Ruff, Wilhelm, Beier, Dauster & Partner mbB
(86) Internationale Anmeldenummer: PCT/EP2020/074895
(87) Internationale Veröffentlichungsnummer: WO 2021/069159

(56) Entgegenhaltungen:
- JP-A- H07 240 318
- JP-U- H0 313 713
- JP-Y2- 2 523 111

## Beschreibung

Die Erfindung betrifft eine Einrichtung zum Absorbieren von elektrischem Rauschen auf Leitungen nach Anspruch 1, mit einem zwei Gehäuseteile aufweisenden Gehäuse, wobei jedes Gehäuseteil zun Aufnehmen je eines Elements aus einem Rauschen absorbierenden Material vorgesehen ist, wobei das Gehäuse im geschlossenen Zustand in zwei gegenüberliegenden Stirnwänden je eine Durchgangsöffnung für eine oder mehrere Leitungen aufweist, wobei die Elemente in den Gehäuseteilen im geschlossenen Zustand des Gehäuses einen Durchgang für eine oder mehrere Leitungen bilden, wobei die Durchgangsöffnungen im Gehäuse und der mittels der Elemente gebildete Durchgang eine Durchgangsrichtung für die wenigstens eine Leitung definieren und wobei eine Verriegelungseinrichtung zum Verriegeln der Gehäuseteile in geschlossenem Zustand des Gehäuses vorgesehen ist. Die Erfindung betrifft auch ein Verfahren zum Anordnen einer erfindungsgemäßen Einrichtung auf wenigstens einer elektrischen Leitung gemäß Anspruch 15.

Aus der europäischen Patentschrift EP 2630648 B1 ist eine Einrichtung zum Absorbieren von elektrischem Rauschen auf Leitungen mit einem zwei Gehäuseteile aufweisenden Gehäuse bekannt, wobei jedes Gehäuseteil zum Aufnehmen je eines Elements aus einem Rauschen absorbierenden Material vorgesehen ist. Die beiden Gehäuseteile können mittels eines Filmscharniers miteinander verbunden sein und mittels einer Klappbewegung um das Scharnier geschlossen und aneinander verriegelt werden. Ebenfalls beschrieben ist, dass die beiden Gehäuseteile getrennt voneinander sind und mit einer linearen Bewegung senkrecht zu einer eingelegten elektrischen Leitung aufeinander zubewegt und aneinander verriegelt werden.

Aus der europäischen Patentschrift EP 2911311 B1 ist eine weitere Einrichtung zum Absorbieren von elektrischem Rauschen auf Leitungen mit einem zwei Gehäuseteile aufweisenden Gehäuse bekannt, wobei jedes Gehäuseteil zum Aufnehmen je eines Elements aus einem Rauschen absorbierenden Material vorgesehen ist. Die beiden Gehäuseteile können mittels einer Linearführung miteinander verbunden sein und mittels einer linearen Schiebebewegung können die beiden Gehäuseteile in den geschlossenen Zustand des Gehäuses bewegt werden. Die lineare Bewegung erfolgt senkrecht zu einer eingelegten elektrischen Leitung.

Aus JP H07 240318 A, JP 2 523111 Y2 und JP H03 13713 U sind jeweils weitere Filtereinrichtungen bekannt, bei denen zwei Gehäusehälften entlang eines Kabels ineinander geschoben werden. Dabei weisen die Gehäusehälften jeweils zum Kabel parallele Kanten auf.

Mit der Erfindung soll eine Einrichtung zum Absorbieren von elektrischem Rauschen auf Leitungen und ein Verfahren zum Anordnen einer solchen Einrichtung bezüglich des Platzbedarfs verbessert werden, der zum Anordnen der Einrichtung auf einer elektrischen Leitung benötigt wird.

Erfindungsgemäß ist hierzu eine Einrichtung zum Absorbieren von elektrischem Rauschen auf Leitungen mit einem zwei Gehäuseteile aufweisenden Gehäuse vorgesehen, wobei jedes Gehäuseteil zum Aufnehmen je eines Elements aus einem Rauschen absorbierenden Material vorgesehen ist, wobei das Gehäuse in geschlossenem Zustand in zwei gegenüberliegenden Stirnwänden je eine Durchgangsöffnung für eine oder mehrere Leitungen aufweist, wobei die Elemente in den Gehäuseteilen in geschlossenem Zustand des Gehäuses einen Durchgang für eine oder mehrere Leitungen bilden, wobei die Durchgangsöffnungen im Gehäuse und der mittels der Elemente gebildete Durchgang eine Durchgangsrichtung für die wenigstens eine Leitung definieren und wobei eine Verriegelungseinrichtung zum Verriegeln der Gehäuseteile im geschlossenen Zustand des Gehäuses vorgesehen ist, bei der die Gehäuseteile so ausgebildet sind, dass die Gehäuseteile mittels einer Relativbewegung der Gehäuseteile zueinander, wobei eine Hauptkomponente der Relativbewegung parallel zu der Durchgangsrichtung verläuft, in den geschlossenen Zustand des Gehäuses bewegt und in dem geschlossenen Zustand aneinander verriegelt werden können.

Eine Relativbewegung der Gehäuseteile zueinander erfolgt über wenigstens ein Drittel der durch die Relativbewegung zurückgelegten Strecke parallel zur Durchgangsrichtung, also parallel zu der wenigstens einen Leitung. Beispielsweise kann die Relativbewegung zunächst eine bogenförmige Annäherung der beiden Gehäuseteile vorsehen, bis dann über wenigstens ein Drittel der Strecke der Relativbewegung eine Bewegung parallel zu der Durchgangsrichtung erfolgt, um das Gehäuse in den geschlossenen Zustand zu bringen und die beiden Gehäuseteile aneinander zu verriegeln. Eine Bewegung der beiden Gehäuseteile kann beispielsweise auch zunächst schräg aber linear zur Durchgangsrichtung erfolgen und dann über wenigstens ein Drittel der Strecke der Relativbewegung parallel zur Durchgangsrichtung. Durch die Relativbewegung mit einer Hauptkomponente der Relativbewegung parallel zu der Durchgangsrichtung ist die erfindungsgemäße Einrichtung gerade bei beschränkten Platzverhältnissen vorteilhaft, da kein Raum zum Klappen der beiden Gehäuseteile oder kein Raum oder nur wenig Raum für eine Relativbewegung senkrecht zur Durchgangsrichtung benötigt wird.

Indem die beiden Gehäuseteile mittels einer Relativbewegung im Wesentlichen parallel zu der Durchgangsrichtung in den geschlossenen Zustand des Gehäuses gebracht und gleichzeitig aneinander verriegelt werden, wird für das Anordnen der Einrichtung zum Absorbieren von elektrischem Rauschen auf einer oder mehreren Leitungen weniger Raum benötigt als bei konventionellen Einrichtungen. Denn die Relativbewegung weist eine Hautkomponente parallel zu der Durchgangsrichtung auf, verläuft also im Wesentlichen parallel zu der Durchgangsrichtung. Damit wird senkrecht zur Leitung lediglich sehr wenig Platz benötigt, im Extremfall lediglich so viel Platz, dass die beiden Gehäuseteile an der Leitung angeordnet und auf der Leitung parallel zu der Leitung verschoben werden können. Gerade dann, wenn Einrichtungen zum Absorbieren von elektrischem Rauschen innerhalb von Gehäusen einer elektrischen oder elektronischen Einrichtung angeordnet werden, bietet die erfindungsgemäße Einrichtung Vorteile. Die erfindungsgemäße Einrichtung kann selbstverständlich auch bei großzügigen Platzverhältnissen, beispielsweise auf einer Zuleitung zu einem Gehäuse eines elektronischen oder elektrischen Geräts, montiert werden.

Dadurch, dass sowohl das Zusammenschieben der beiden Gehäuseteile als auch das Verriegeln der beiden Gehäuseteile in den geschlossenen Zustand aneinander mittels ein- und derselben Relativbewegung erfolgt, kann die erfindungsgemäße Einrichtung schnell und problemlos und gegebenenfalls automatisiert auf einer oder mehreren Leitungen angeordnet werden. Die Relativbewegung kann dabei vollständig geradlinig oder beispielsweise zu mindestens einem Drittel des zurückzulegenden Wegs geradlinig sein. Die Platzersparnis gegenüber konventionellen Einrichtungen beim Anordnen der Einrichtung auf einer oder mehreren Leitungen wird dadurch erreicht, dass eine Hauptkomponente der Relativbewegung parallel zu der Durchgangsrichtung verläuft. Die Relativbewegung verläuft also im Wesentlichen und insbesondere wenigstens über ein Drittel der zurückgelegten Strecke parallel zu der Durchgangsrichtung. Die zurückgelegte Strecke wird dabei von einem ersten Kontakt der Gehäusehälften bis zum vollständig geschlossenen und verriegelten Zustand das Gehäuses gemessen. Die Elemente aus einem Rauschen absorbierenden Material sind beispielsweise aus Ferritmaterial hergestellt, das Gehäuse ist beispielsweise mittels Kunststoffspritzguss aus Kunststoff hergestellt.

In Weiterbildung der Erfindung sind die beiden Gehäuseteile identisch ausgebildet.

Die Ausbildung der Gehäuseteile in der Weise, dass die Gehäuseteile mittels einer Relativbewegung der Gehäuseteile zueinander, wobei eine Hauptkomponente der Relativbewegung parallel zu der Durchgangsrichtung verläuft, in den geschlossenen Zustand des Gehäuses bewegt und in dem geschlossenen Zustand aneinander verriegelt werden können, erlaubt die identische Ausbildung der beiden Gehäuseteile. Dies erleichtert die Herstellung der erfindungsgemäßen Einrichtung in großen Stückzahlen erheblich, da lediglich eine Form oder mehrere identische Formnester für das Herstellen des Gehäuses der Einrichtung benötigt werden. Beispielsweise wird das Gehäuse der Einrichtung mittels Kunststoffspritzguss hergestellt. Ein Kunststoffspritzgusswerkzeug kann dann mehrere, identische Formnester für jeweils ein Gehäuseteil aufweisen.

Erfindungsgemäß ist das Gehäuse mittels der Gehäuseteile schräg zu der Durchgangsrichtung geteilt.

Auf diese Weise kann durch die Formgebung der Gehäuseteile ein Endanschlag für die Relativbewegung beim Verbinden der beiden Gehäuseteile realisiert werden. Die beiden Gehäuseteile werden im Wesentlichen parallel zu der Durchgangsrichtung so lange aufeinander zubewegt, bis schräg zu der Durchgangsrichtung verlaufende Flächen der beiden Gehäuseteile aneinander anliegen.

In Weiterbildung der Erfindung sind die Elemente im geschlossenen Zustand des Gehäuses schräg zu der Durchgangsrichtung geteilt.

Auch die Elemente aus einem Rauschen absorbierenden Material, beispielsweise Ferritelemente, können schräg zu der Durchgangsrichtung geteilt sein und dadurch schräg zu der Durchgangsrichtung angeordnete Anschlagflächen bereitstellen. Üblicherweise werden die Elemente aus einem Rauschen absorbierenden Material im geschlossenen Zustand des Gehäuses der Einrichtung so angeordnet, dass diese dicht aneinander anliegen. Dieser Zustand kann dann gleichzeitig den geschlossenen Zustand des Gehäuses definieren.

In Weiterbildung der Erfindung sind die Gehäuseteile mit einer Schiebeführung versehen.

Auf diese Weise kann die Relativbewegung mittels der Schiebeführung wenigstens abschnittsweise definiert werden, so dass die korrekte Positionierung der beiden Gehäuseteile zueinander und auch deren korrekte Verriegelung im geschlossenen Zustand des Gehäuses sichergestellt werden kann.

In Weiterbildung der Erfindung ist die Schiebeführung als Kulissenführung ausgebildet.

Kulissenführungen können in flexibler Weise ausgestaltet werden und beispielsweise Einführungsschrägen und Rastmittel definieren. Dadurch kann sowohl die Funktion des Führens der beiden Gehäuseteile aneinander während der Relativbewegung als auch die Verriegelung der beiden Gehäuseteile aneinander mittels der Kulissenführung realisiert werden.

In Weiterbildung der Erfindung ist die Schiebeführung mittels Führungsschienen als Linearführung ausgebildet.

Führungsschienen ermöglichen eine definierte Relativbewegung, um die beiden Gehäuseteile in den geschlossenen Zustand des Gehäuses zu bewegen. Schiebeführungen können beispielsweise an Kunststoffspritzgussteilen prozesssicher mit den erforderlichen Toleranzen, die einerseits eine leichte Beweglichkeit und andererseits eine exakte Positionierung der Gehäusehälften zueinander ermöglichen, ausgeführt werden.

In Weiterbildung der Erfindung weist die Verriegelungseinrichtung Rastmittel mit Rastvorsprüngen und Rastausnehmungen auf.

Mittels Rastvorsprüngen und Rastausnehmungen können die beiden Gehäuseteile sicher aneinander verriegelt werden. Zweckmäßigerweise werden die Rastvorsprünge und Rastausnehmungen so ausgebildet, dass der korrekt verriegelte Zustand der Rastvorsprünge und Rastausnehmungen von der Außenseite der Einrichtung, insbesondere von einer Außenseite des Gehäuses, erkennbar ist. Dies erleichtert einem Benutzer das Erkennen der korrekten Verriegelung, kann bei automatisierter Montage aber auch dazu dienen, den korrekt verriegelten Zustand mittels Kameras und Bildverarbeitung oder in sonstiger automatisierter Weise zu erkennen.

In Weiterbildung der Erfindung sind die Rastmittel getrennt von der Schiebeführung angeordnet.

Auf diese Weise ist die Ausbildung der Rastmittel unabhängig von der Ausbildung der Schiebeführungen, so dass sowohl die Schiebeführung als auch die Rastmittel auf ihre jeweilige Funktion hin optimiert werden können.

In Weiterbildung der Erfindung weisen die Rastmittel federnde Rastarme auf.

Mittels federnder Rastarme kann eine automatische Verriegelung am Ende der Relativbewegung der beiden Gehäusehälften zueinander zuverlässig realisiert werden. Die Rastarme können als einseitig befestigte Arme oder auch als an beiden Enden befestigte federnde Bügel, insbesondere U-Bügel, ausgebildet sein.

In Weiterbildung der Erfindung sind die Rastmittel an der Schiebeführung angeordnet.

Auf diese Weise können die Rastmittel platzsparend angeordnet werden.

In Weiterbildung der Erfindung weisen die Rastmittel wenigstens eine Rastausnehmung in der Schiebeführung auf.

Mittels einer Rastausnehmung in der Schiebeführung, in die ein Rastvorsprung an dem zugehörigen Teil der Schiebeführung am anderen Gehäuseteil eingreifen kann, kann eine platzsparende und dabei sichere Verriegelung der beiden Gehäuseteile im geschlossenen Zustand des Gehäuses aneinander sichergestellt werden. Vorteilhaft blockieren die Rastausnehmung und der Rastvorsprung, wenn sie eingesetzt sind, eine Relativbewegung der Gehäuseteile in und entgegen der Durchgangsrichtung.

In Weiterbildung der Erfindung ist wenigstens eines der Elemente, beispielsweise Ferritelemente, mit wenigstens einer Anlaufschräge versehen, wobei die Anlaufschräge eines Elements bei der Relativbewegung vom geöffneten in den geschlossenen Zustand des Gehäuses auf das jeweilige andere Element aufläuft.

Um gute elektrische und magnetische Eigenschaften der Elemente zum Absorbieren des Rauschens, beispielsweise Ferritelemente, im geschlossenen Zustand des Gehäuses zu gewährleisten, werden die beiden Elemente, die beispielsweise jeweils rinnenförmig ausgebildet sind, im geschlossenen Zustand des Gehäuses dicht und im Wesentlichen ohne Spalt aneinander gehalten. Eine solche Endposition der beiden Elemente zueinander wird dadurch in zuverlässiger Weise erreicht, dass während der Relativbewegung der beiden Gehäuseteile zueinander die Elemente mittels Anlaufschrägen aneinander anstoßen und dann schon während der Relativbewegung aneinandergepresst werden. Dadurch können die Elemente im geschlossenen Zustand des Gehäuses sehr dicht und im Wesentlichen ohne Spalt aneinander anliegen.

In Weiterbildung der Erfindung ist zwischen jeweils einem Element und dem zugeordneten Gehäuseteil eine Federeinrichtung vorgesehen, um das Element bei geschlossenem Gehäuse in Richtung auf das Element im anderen Gehäuseteil vorzuspannen.

Mittels mindestens einer Federeinrichtung werden die Elemente aufeinander zu vorgespannt und es kann sichergestellt werden, dass die Elemente, beispielsweise jeweils rinnenartig ausgebildete Ferritelemente, im geschlossenen Zustand des Gehäuses mit ihren Anlageflächen im Wesentlichen spaltfrei aneinanderliegen.

In Weiterbildung der Erfindung weist die Federeinrichtung eine Blattfeder auf.

Blattfedern sind äußerst platzsparend ausführbar und können dennoch eine vergleichsweise hohe Federkraft bereitstellen. Beim Aneinanderpressen der beiden Elemente wird lediglich ein geringer Federweg benötigt, eine große Federkraft ist aber vorteilhaft, um das im Wesentlichen spaltfreie Aneinanderliegen der beiden Elemente sicherzustellen. Diese Anforderungen können Blattfedern erfüllen. Geeignete Blattfedern sind beispielsweise kreisscheibenförmig oder auch rechteckig ausgebildet.

Das der Erfindung zugrunde liegende Problem wird auch durch ein Verfahren zum Anordnen einer erfindungsgemäßen Einrichtung zum Absorbieren von elektrischem Rauschen auf wenigstens einer Leitung gelöst, wobei die beiden Gehäuseteile des Gehäuses der Einrichtung mittels einer Relativbewegung der Gehäuseteile zueinander in den geschlossenen Zustand des Gehäuses bewegt und in dem geschlossenen Zustand aneinander verriegelt werden, wobei eine Hauptkomponente der Relativbewegung parallel zu der Durchgangsrichtung verläuft. Weitere Merkmale und Vorteile der Erfindung ergeben sich aus den Ansprüchen und der folgenden Beschreibung bevorzugter Ausführungsformen der Erfindung im Zusammenhang mit den Zeichnungen. Einzelmerkmale der unterschiedlichen Ausführungsformen können dabei in der in den Ansprüchen genannten Weise miteinander kombiniert werden, ohne den Rahmen der Erfindung zu überschreiten. Dies gilt auch für die Kombination von Einzelmerkmalen ohne weitere Einzelmerkmale, mit denen sie im Zusammenhang gezeigt oder beschrieben sind. In den Zeichnungen zeigen:
- Fig. 1: eine Darstellung einer nicht erfindungesgemäßen ersten Ausführungsform im geöffneten Zustand eines Gehäuses,
- Fig. 2: eine Seitenansicht der Einrichtung der Fig. 1,
- Fig. 3: eine Ansicht einer weiteren nicht erfindungsgemäßen Einrichtung von schräg vorne oben im geschlossenen Zustand des Gehäuses,
- Fig. 4: die Einrichtung der Fig. 3 von schräg hinten oben,
- Fig. 5: das untere Gehäuseteil der Einrichtung der Fig. 3 von schräg oben,
- Fig. 6: das Gehäuseteil der Fig. 5 von vorne,
- Fig. 7: das Gehäuseteil der Fig. 5 von schräg hinten ohne das in Fig. 5 gezeigte Element zum Absorbieren des Rauschens,
- Fig. 8: die beiden Elemente zum Absorbieren des Rauschens der Einrichtung der Fig. 3 ohne die Gehäuseteile,
- Fig. 9: eine Einrichtung zum Absorbieren von elektrischem Rauschen auf Leitungen gemäß einer Ausführungsform der Erfindung von schräg vorne,
- Fig. 10: das untere Gehäuseteil der Einrichtung der Fig. 9 mit eingelegtem Ferritelement,
- Fig. 11: das Gehäuseteil der Fig. 10 ohne das Ferritelement,
- Fig. 12: das Ferritelement des Gehäuseteils der Fig. 10,
- Fig. 13: eine weitere Einrichtung zum Absorbieren von elektrischem Rauschen auf Leitungen gemäß einer weiteren erfindungsgemäßen

### Ausführungsform von schräg vorne

- Fig. 14: das untere Gehäuseteil der Einrichtung der Fig. 13 mit eingelegtem Ferritelement,
- Fig. 15: das Gehäuseteil der Fig. 14 ohne das Ferritelement,
- Fig. 16: die Einrichtung der Fig. 13 ohne das obere Gehäuseteil,
- Fig. 17: die Einrichtung der Fig. 13 in einer Seitenansicht,
- Fig. 18: das Gehäuseteil der Fig. 15 in einer Draufsicht,
- Fig. 19: das untere Ferritelement der Einrichtung der Fig. 12 mit einer zugeordneten Blattfeder im entspannten Zustand und
- Fig. 20: das Ferritelement und die Blattfeder der Fig. 18 im komprimierten Zustand der Blattfeder.

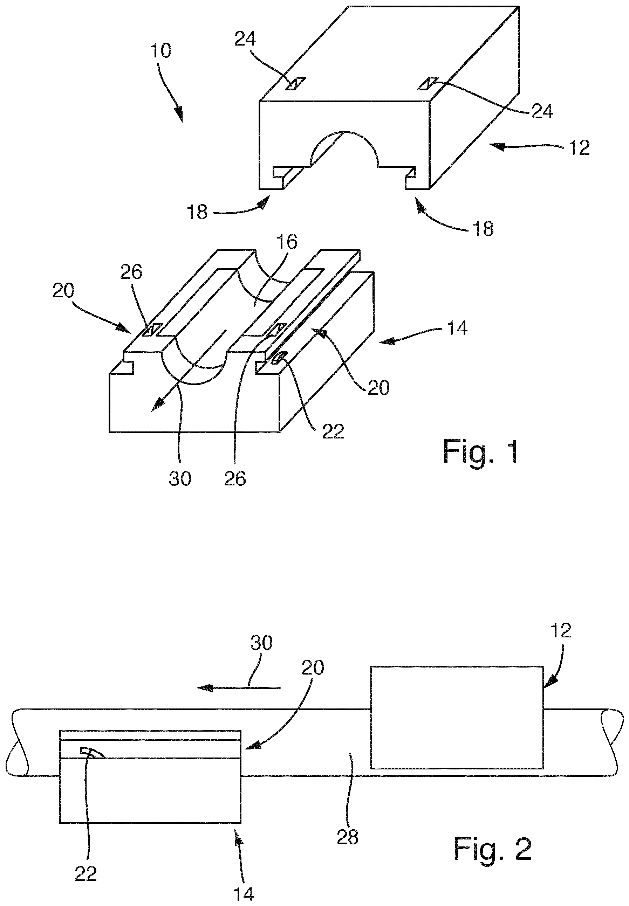

Die Darstellung der Fig. 1 zeigt eine nicht erfindungsgemäße Einrichtung 10 zum Absorbieren von elektrischem Rauschen auf Leitungen. Die Einrichtung 10 weist ein erstes Gehäuseteil 12 und ein zweites Gehäuseteil 14 auf. In jedem der Gehäuseteile 12, 14 ist ein Element aus einem Rauschen absorbierenden Material vorgesehen, beispielsweise ein Ferritelement 16, wobei das Ferritelement in dem in Fig. 1 oberen Gehäuseteil 12 nicht zu erkennen ist. Das Ferritelement 16 ist rinnenförmig ausgebildet. Im geschlossenen Zustand des Gehäuses, wenn also das in Fig. 1 obere Gehäuseteil 12 auf das in Fig. 1 untere Gehäuseteil 14 aufgesetzt ist, bilden die beiden Ferritelemente 16 einen in radialer Richtung geschlossenen Durchgang für eine oder mehrere nicht dargestellte Leitungen.

Im geschlossenen Zustand des Gehäuses bilden auch die beiden Gehäuseteile 12, 14 an ihren gegenüberliegenden Stirnwänden, in Fig. 1 vorne, dem Betrachter zugewandt, und hinten, dem Betrachter abgewandt, je eine Durchgangsöffnung für eine oder mehrere nicht dargestellte Leitungen.

Um das Gehäuse der Einrichtung 10 ausgehend von dem in Fig. 1 dargestellten geöffneten Zustand in den geschlossenen Zustand zu bringen, wird das erste Gehäuseteil 12 an die hintere Stirnwand des zweiten Gehäuseteils 14 so angesetzt, dass Führungsleisten 18 am ersten Gehäuseteil 12 in Führungsleisten 20 am zweiten Gehäuseteil 14 eingreifen. Das erste Gehäuseteil 12 kann dann nur noch parallel zu einer Durchgangsrichtung 30, die parallel zu den Führungsleisten 18, 20 verläuft und die auch parallel zu einer in Fig. 1 nicht dargestellten aber in Fig. 2 gezeigten Leitung 28 verläuft, die in das untere Ferritelement 16 eingelegt ist, relativ zum zweiten Gehäuseteil 14 verschoben werden. Das erste Gehäuseteil 12 wird so lange parallel zu der Durchgangsrichtung 30 verschoben, bis die in Fig. 1 vordere Stirnwand des ersten Gehäuseteils 12 mit der in Fig. 1 vorderen Stirnwand des zweiten Gehäuseteils 14 fluchtet. Damit ist der geschlossene Zustand des Gehäuses erreicht, in dem die beiden Ferritelemente 16 einen im Wesentlichen in radialer Richtung geschlossenen und in axialer Richtung offenen Durchgang für die Leitung bilden. Die beiden Gehäuseteile 12, 14 sind dann auch in Richtungen senkrecht zu der Durchgangsrichtung sicher aneinander fixiert. Lediglich in und entgegen der Durchgangsrichtung 30 wäre eine Verschiebung der beiden Gehäuseteile 12, 14 zueinander möglich. Im geschlossenen Zustand des Gehäuses greifen aber federnde Rastarme 22 an den Führungsleisten 20, von denen in Fig. 1 lediglich eine erkennbar ist, in nicht dargestellte, passende Ausnehmungen an den Führungsleisten 18 des ersten Gehäuseteils 12 ein. Dadurch wird eine Verschiebung der beiden Gehäuseteile 12, 14 im geschlossenen Zustand des Gehäuses auch in und entgegen der Durchgangsrichtung 30 weitgehend verhindert.

Um die beiden Gehäuseteile 12, 14 wieder voneinander lösen zu können, sind fluchtend zu den Ausnehmungen in den Führungsleisten 18 Schlüsselöffnungen 24 im ersten Gehäuseteil 12 und Schlüsselöffnungen 26 in den Führungsleisten 20 des unteren Gehäuseteils 14 vorgesehen. Im geschlossenen Zustand des Gehäuses fluchten die Schlüsselöffnungen 24, 26 miteinander und, wie ausgeführt, fluchten die Schlüsselöffnungen 24, 26 auch mit den Rastausnehmungen in den Führungsleisten 18. In den Schlüsselöffnungen 24, 26 kann somit ein passender Schlüssel mit zwei parallel zueinander angeordneten leistenartigen Vorsprüngen angeordnet werden. Wird dieser Schlüssel dann in Richtung auf das zweite Gehäuseteil 14 gedrückt, drücken die Vorderkanten der leistenartigen Vorsprünge die federnden Rastarme 22 aus den Ausnehmungen in den Führungsleisten 18 heraus und die beiden Gehäuseteile 12, 14 können dann wieder relativ zueinander in und entgegen der Durchgangsrichtung 30 verschoben werden.

Einer der federnden Rastarme 22 ist in der Seitenansicht des zweiten Gehäuseteils 14 in Fig. 2 zu erkennen. Es können in der durch die Führungsleisten 18, 20 definierten Schiebeführung auch mehreren federnde Rastarme vorgesehen sein, deren Ausbildung auch anders sein kann als in Fig. 2 dargestellt. Beispielsweise kann der Rastarm 22 auch so ausgebildet sein, dass er eine Schiebebewegung in zwei gegenüberliegenden Richtungen, in Fig. 2 also nach links und nach rechts, blockiert. Beispielsweise könnte der federnde Rastarm 22 als federnder Bogen ausgebildet sein, der sich in die Schiebeführung hinein erstreckt. An den Führungsleisten 18 des ersten Gehäuseteils könnte in diesem Fall dann beispielsweise eine passende Vertiefung ausgebildet sein, die, wie erläutert wurde, auch durch die Fortsetzung der Schlüsselöffnungen 24, 26 gebildet sein kann.

Wesentlich ist, dass die beiden Gehäuseteile 12, 14 mittels einer Relativbewegung zueinander, die parallel zu der Durchgangsrichtung 30 der Leitung durch das Gehäuse verläuft, von dem in Fig. 1 dargestellten geöffneten Zustand in den geschlossenen Zustand des Gehäuses gebraucht werden und dass durch diese Relativbewegung gleichzeitig eine Verriegelung der beiden Gehäuseteile 12, 14 im geschlossenen Zustand des Gehäuses aneinander erfolgt. Es ist anhand der Fig. 1 und auch der Fig. 2 zu erkennen, dass zum Bewegen der beiden Gehäuseteile 12, 14 in den geschlossenen Zustand des Gehäuses senkrecht zur Durchgangsrichtung 30 lediglich so viel Platz benötigt wird, um die beiden Gehäuseteile 12, 14 auf der Leitung 28 anzuordnen. Zusätzlicher Raum oberhalb und unterhalb des ersten Gehäuseteils 12 und des zweiten Gehäuseteils 14 wird hingegen nicht benötigt. Die erfindungsgemäße Einrichtung ist dadurch besonders für beengte Platzverhältnisse geeignet, beispielsweise innerhalb eines Gehäuses einer elektrischen oder elektronischen Einrichtung. Ausgehend von dem geöffneten Zustand des Gehäuses gemäß Fig. 1 und Fig. 2 müssen die beiden Gehäuseteile 12, 14, siehe Fig. 2, also lediglich parallel zu der Durchgangsrichtung 30, die parallel zu der Leitung 28 verläuft, zueinander verschoben werden, um in den geschlossenen Zustand des Gehäuses gebracht und gleichzeitig mittels der federnden Rastarme 22 aneinander verriegelt zu werden.

Die Durchgangsrichtung 30 wird mittels der rinnenförmigen Ausnehmungen in den Ferritelementen 16 und den jeweils etwa halbkreisförmigen Durchgangsöffnungen in den Stirnwänden der beiden Gehäuseteile 12, 14 definiert. Im geschlossenen Zustand des Gehäuses wird die Durchgangsrichtung 30 also mittels des durch die Ferritelemente 16 dann gebildeten geschlossenen, zylinderförmigen Durchgangs und die dann kreisförmigen Durchgangsöffnungen in den Stirnseiten des Gehäuses definiert. Eine oder mehrere Leitungen werden parallel zu der Durchgangsrichtung 30 durch das Gehäuse der Einrichtung 10 geführt.

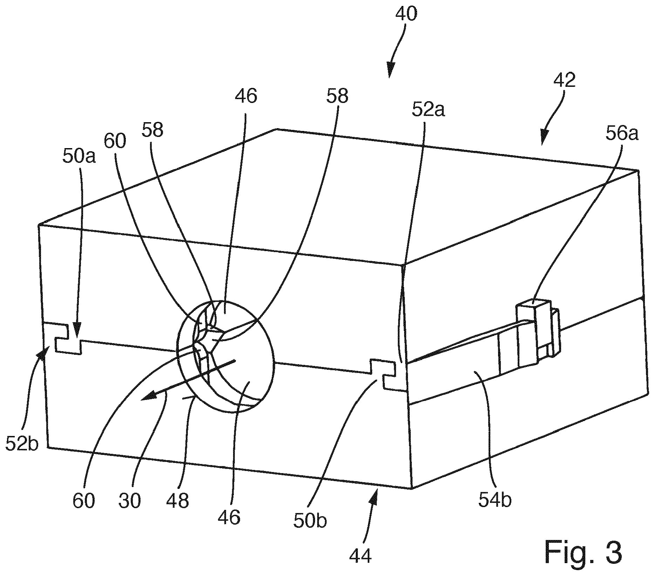

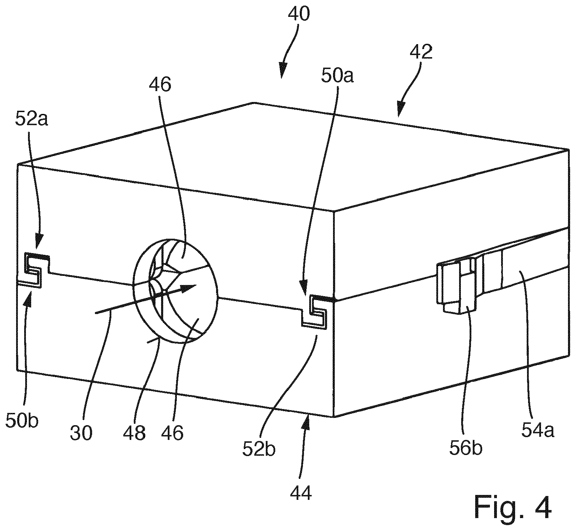

Die Darstellungen der Fig. 3 und der Fig. 4 zeigen eine weitere nicht erfindungsgemäße Einrichtung 40. Fig. 3 zeigt die Einrichtung 40 von schräg oben vorne und Fig. 4 von schräg oben hinten. Die Einrichtung 40 weist ein erstes Gehäuseteil 42 und ein zweites Gehäuseteil 44 auf, wobei die beiden Gehäuseteile 42, 44 identisch ausgebildet sind. In jedem der beiden Gehäuseteile 42, 44 ist ein rinnenförmig ausgebildetes Ferritelement 46 vorgesehen, wobei die Ferritelemente 46 im in Fig. 3 und Fig. 4 dargestellten geschlossenen Zustand des Gehäuses einen in radialer Richtung geschlossenen zylindrischen Durchgang für eine oder mehrere Leitungen bilden. Die Stirnseiten des Gehäuses der Einrichtung 40, die in Fig. 3 und Fig. 4 vorne bzw. hinten liegen, weisen jeweils eine Durchgangsöffnung 48 für eine oder mehrere Leitungen auf. Das erste Gehäuseteil 42 und das zweite Gehäuseteil 44 sind jeweils mit Führungsleisten 50a, 50b, 52a, 52b versehen, die zusammen eine Schiebeführung bilden. Die Führungsleisten 50a am ersten Gehäuseteil 42 greifen in die Führungsleisten 52b des zweiten Gehäuseteils 44 ein, siehe in Fig. 3 die linke Seite der Einrichtung 40. Die Führungsleisten 52a des ersten Gehäuseteils 42 greifen in die Führungsleisten 50b des zweiten Gehäuseteils 44 ein, siehe in Fig. 3 die rechte Seite der Einrichtung 40. Dadurch können die beiden Gehäusehälften 42, 44 identisch zueinander ausgebildet sein und mittels der Führungsleisten 50a, 50b, 52a, 52b eine Schiebeführung bilden.

Auf der in Fig. 3 rechten Seite der Einrichtung 40 ist ein federnder Rastarm 54b zu erkennen. Der federnde Rastarm 54b ist einstückig mit dem zweiten Gehäuseteil 44 ausgebildet und greift im dargestellten geschlossenen Zustand des Gehäuses in eine mittels eines Bügels gebildete Rastausnehmung 56a am ersten Gehäuseteil 42 ein. Auf der in Fig. 3 nicht sichtbaren linken Seite des ersten Gehäuseteils 42 ist dieses mit einem weiteren federnden Rastarm 54a versehen und das zweite Gehäuseteil 44 ist auf der in Fig. 3 nicht sichtbaren linken Seite mit einem Bügel versehen, der dann die Rastausnehmung 56b bildet, siehe auch Fig. 4. Der Bügel kann L-förmig oder auch U-förmig ausgebildet sein.

Werden die beiden Gehäuseteile 42, 44 ausgehend von einem geöffneten Zustand des Gehäuses so aneinander angesetzt, dass die Führungsleisten 50, 52 ineinander eingreifen, und werden die beiden Gehäuseteile 42, 44 dann in der Durchgangsrichtung 30 verschoben, werden die Rastarme 54 zunächst ausgelenkt und schnappen dann, wenn die beiden Gehäuseteile 42, 44 die in Fig. 3 dargestellte geschlossene Stellung des Gehäuses erreicht haben, in die mittels der Bügel gebildeten Rastausnehmungen 56 ein. In Fig. 4 sind Einführungsschrägen oder Einführungsfasen am Beginn der Führungsleisten 50a, 50b, 52a, 52b zu erkennen, die das Ansetzen und Einführen der Führungsleisten 50a, 50b, 52a, 52b ineinander erleichtern.

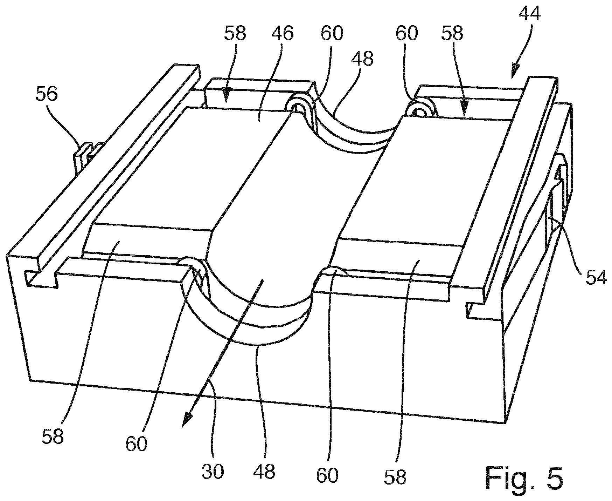

Fig. 5 zeigt das zweite Gehäuseteil 44 der Fig. 3 und in Fig. 4 in einer Darstellung von schräg oben. Zu erkennen ist das in dem trogartig ausgebildeten zweiten Gehäuseteil 44 angeordnete Ferritelement 46. Das Ferritelement 46 ist allgemein rinnenförmig ausgebildet und weist eine zylindrische Ausnehmung mit etwa halbkreisförmigem Querschnitt zum Aufnehmen einer oder mehrerer elektrischer Leitungen auf, vgl. die Leitung 28 in Fig. 2. Seitlich der Ausnehmungen weist das Ferritelement 46 an seiner in Fig. 4 sichtbaren Vorderkante Anlaufschrägen 58 auf. Identisch ausgebildete Anlaufschrägen 58 sind auch auf der in Fig. 4 dem Betrachter abgewandten Rückseite des Ferritelements 46 angeordnet. Das Ferritelement 46 im ersten Gehäuseteil 42, siehe Fig. 3, ist identisch ausgebildet.. Wenn die beiden Gehäuseteile 42, 44 relativ zueinander parallel zur Durchgangsrichtung 30 aufeinander aufgeschoben werden, gelangen die vorderen Anlaufschrägen 58 des Ferritelements 46 im ersten Gehäuseteil 42 in Anlage an die in Fig. 3 hinteren Anlaufschrägen 58 des Ferritelements 46 des zweiten Gehäuseteils 44. Die Anlaufschrägen 58 können dann aneinander vorbeigleiten, wobei die Ferritelemente 46 in Richtung auf den Grund des jeweiligen Gehäuseteils 42, 44 gedrückt werden. Dies wird durch Federelemente zwischen dem Boden des jeweiligen Gehäuseteils 42, 44 und den Ferritelementen 46 ermöglicht. Im geschlossenen Zustand des Gehäuses, siehe Fig. 3 und Fig. 4, liegen die beiden Ferritelemente 46 dann im Wesentlichen spaltfrei aneinander und bilden einen in radialer Richtung geschlossenen Durchgang für eine Leitung 28, vgl. Fig. 2.

In Fig. 5 sind seitlich der Durchgangsöffnungen 48 am zweiten Gehäuseteil 44 U-förmige Bügel 60 zu erkennen. Links und rechts der halbkreisförmigen Durchgangsöffnung 48 ist jeweils ein U-förmiger Bügel 60 angeordnet. Die U-förmigen Bügel 60 sind mit ihrer offenen, in Fig. 5 nicht erkennbaren Seite fest und einstückig mit dem Boden des zweiten Gehäuseteils 44 verbunden. Oberhalb des Bodens sind die über eine Basis verbundenen Schenkel der Bügel 60 aber frei, so dass die Bügel 60 auf Druck hin seitlich ausweichen können. Eine in das Ferritelement 46 eingelegte Leitung kann bei entsprechender Dicke dadurch mittels der U-förmigen Bügel 60 eingeklemmt werden. Im geschlossenen Zustand des Gehäuses, siehe Fig. 3, sind an jeder Durchgangsöffnung 48 somit vier U-förmige Bügel 60 angeordnet, die dann die Leitung klemmen und damit die Einrichtung 40 in der festgelegten Position an der Leitung halten.

In Fig. 5 ist auf der linken Seite des zweiten Gehäuseteils 44 der Bügel zu erkennen, der die Rastausnehmung 56 bildet. Auf der in Fig. 5 rechten Seite des zweiten Gehäuseteils 44 ist die Ausbildung des Rastarms 54 zu erkennen, der beim Zusammenschieben der beiden Gehäuseteile 42, 44 in die Rastausnehmung 56 des ersten Gehäuseteils 42 einrastet und dadurch die beiden Gehäuseteile 42, 44 im geschlossenen Zustand des Gehäuses aneinander verriegelt.

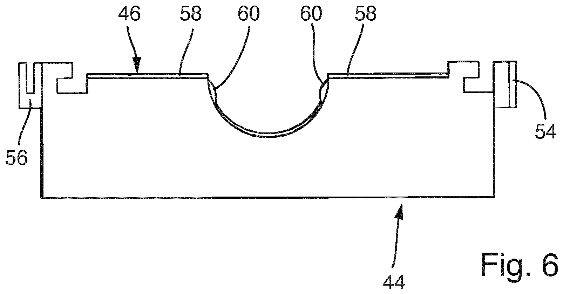

Die Darstellung der Fig. 6 zeigt das zweite Gehäuseteil 44 der Fig. 5 in einer Vorderansicht. In dieser Vorderansicht ist zu erkennen, dass eine Oberseite des Ferritelements 46 ein Stück weit über die obere Begrenzung des ersten Gehäuseteils 44 hinausragt. Zu erkennen ist in Fig. 6 also ein Abschnitt der in Fig. 5 vorderen Anlaufschrägen 58 des Ferritelements. Diese Position des Ferritelements 46 wird im geöffneten Zustand des Gehäuses mittels einer in Fig. 6 nicht erkennbaren Federeinrichtung zwischen dem Boden des Gehäuseteils 44 und dem Ferritelement 46 bewirkt. Beim Zusammenschieben der beiden Gehäuseteile 42, 44 werden die Ferritelemente 46 dann durch die Wirkung der Anlaufschrägen 58 in Richtung auf den Boden des jeweiligen Gehäuseteils 42, 44 gedrückt und liegen dann im geschlossenen Zustand des Gehäuses, siehe Fig. 3 und Fig. 4, im Wesentlichen spaltfrei aneinander an.

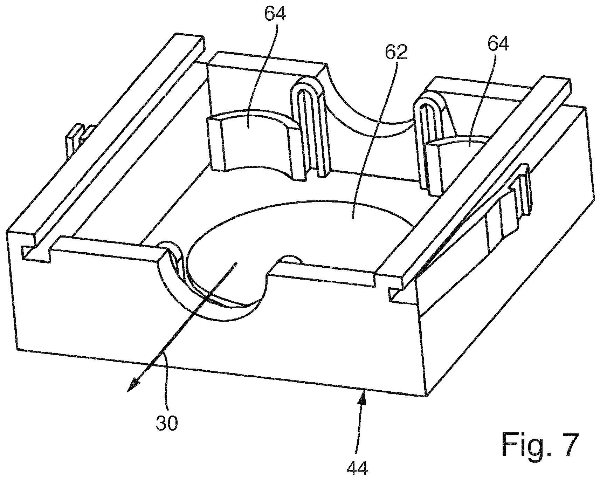

Die Darstellung der Fig. 7 zeigt das zweite Gehäuseteil 44 der Fig. 4 ohne das Ferritelement 46. Am Boden des zweiten Gehäuseteils 44 ist eine Federeinrichtung 62, beispielsweise in Form einer Scheibenfeder, zu erkennen. Diese Federeinrichtung 62 sorgt dafür, dass das Ferritelement 46 vom Boden des zweiten Gehäuseteils 44 weggedrückt wird und die in Fig. 6 erläuterte Position einnimmt. Das Gehäuseteil 42 ist, wie bereits erläutert wurde, identisch zum zweiten Gehäuseteil 44 ausgebildet und weist ebenfalls eine Federeinrichtung 62 auf.

Um das Ferritelement 46 in einer definierten Position innerhalb des zweiten Gehäuseteils 44 zu halten, sind insgesamt vier Federbügel 64 in dem Gehäuseteil 44 vorgesehen, wobei in Fig. 7 lediglich zwei erkennbar sind. Diese Federbügel 64 halten das Ferritelement 46 in und entgegen der Durchgangsrichtung 30 gegen Verrutschen fest. Im Rahmen der Erfindung können anstelle jeweils zweier einander gegenüberliegender Federbügel 64 auch andere Federeinrichtungen oder Klemmeinrichtungen vorgesehen sein, um das Ferritelement sicher und positionsgenau im zweiten Gehäuseteil 44 zu halten. Wie bereits erläutert wurde, ist das erste Gehäuseteil 42 identisch zum zweiten Gehäuseteil 44 ausgebildet, so dass alle diesbezüglichen Erklärungen und Erläuterungen auch für das erste Gehäuseteil 42 gelten.

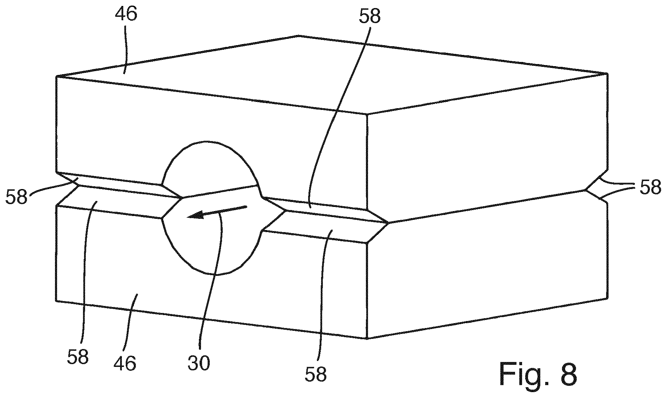

Die Darstellung der Fig. 8 zeigt die beiden Ferritelemente 46 ohne das Gehäuse. Es ist gut zu erkennen, dass die beiden Ferritelemente 46 mit ihren jeweiligen Anlageflächen seitlich des Durchgangs für die Leitung spaltfrei aufeinanderliegen und den in radialer Richtung geschlossenen Durchgang für eine oder mehrere Leitungen bilden. Die Anlaufschrägen 58 der beiden Ferritelemente 46 sind im geschlossenen Zustand des Gehäuses wieder voneinander getrennt, ihre Funktion beim Zusammenschieben der beiden Gehäuseteile 42, 44 wurde bereits erläutert.

Eine Trennebene des Gehäuses der Einrichtung 40 zwischen den beiden Gehäuseteilen 42, 44 und zwischen den beiden Ferritelementen 46 verläuft parallel zur Durchgangsrichtung 30.

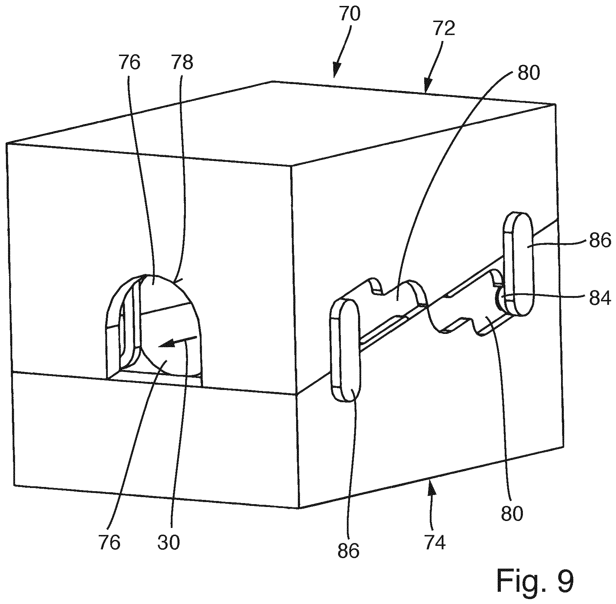

Die Darstellung der Fig. 9 zeigt eine erfindungsgemäße Einrichtung 70. Die Einrichtung 70 weist ein Gehäuse mit zwei identisch zueinander ausgebildeten Gehäuseteilen 72, 74 auf. In jedem der Gehäuseteile 72, 74 ist ein Ferritelement 76 angeordnet. In dem in Fig. 9 dargestellten geschlossenen Zustand des Gehäuses bilden die beiden Ferritelemente 76 einen in radialer Richtung geschlossenen Durchgang für eine oder mehrere Leitungen. Das erste Gehäuseteil 72 ist in seiner, in Fig. 9 links vorne liegenden Stirnseite mit einer U-förmigen Ausnehmung versehen, das zusammen mit der Oberseite der Stirnwand des zweiten Gehäuseteils 74 eine Durchgangsöffnung 78 für eine oder mehrere Leitungen bildet. Die in Fig. 9 dem Betrachter abgewandte Rückseite der Einrichtung 70 ist ebenfalls mit einer Durchgangsöffnung 78 versehen.

Beide Gehäuseteile 72, 74 sind auf ihrer in Fig. 9 sichtbaren Seitenfläche mit jeweils einer Kulissenführung 80 versehen, in die jeweils ein Kulissenstein 84 des jeweils anderen Gehäuseteils 72, 74 eingreift, wobei der Kulissenstein 84 wiederum an einem Arm 86 angeordnet ist, der mit der Seitenwand eines der Gehäuseteile 72, 74 verbunden ist. Die in Fig. 9 nicht sichtbaren Seitenflächen der Gehäuseteile 72, 74 sind identisch zu den in Fig. 9 sichtbaren Seitenflächen ausgebildet.

In der Darstellung der Fig. 9 greift in die Kulissenführung 80 des zweiten Gehäuseteils 74 der Kulissenstein 84 des ersten Gehäuseteils 72 ein, der mittels des Arms 86 einstückig mit dem ersten Gehäuseteil 72 verbunden ist. In analoger Weise greift ein in Fig. 8 nicht erkennbarer Kulissenstein an einem mit dem zweiten Gehäuseteil 74 verbundenen Federarm 86 in die Kulissenführung 80 des ersten Gehäuseteils 72 ein.

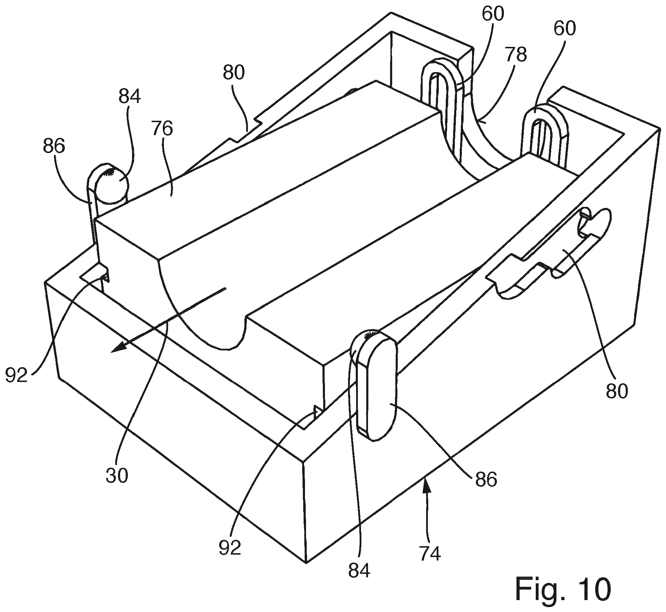

Fig. 10 zeigt lediglich das zweite Gehäuseteil 74 der Einrichtung 70 der Fig. 9. In das zweite Gehäuseteil 74 ist das Ferritelement 76 eingelegt. Es fällt an der Fig. 10 auf, dass eine Oberseite des Gehäuseteils 74 schräg zur Durchgangsrichtung 30 verläuft, die Oberseite des Ferritelements 76 hingegen parallel zur Durchgangsrichtung 30 verläuft. Die beiden Gehäuseteile 72, 74 werden mittels einer Relativbewegung, die im Wesentlichen parallel zur Durchgangsrichtung 30 verläuft, in den geschlossenen Zustand des Gehäuses bewegt. Die jeweils schräg zur Durchgangsrichtung 30 angeordnete Oberseite der Gehäuseteile 72, 74 sorgt dann für einen definierten Endanschlag, wenn der geschlossene Zustand des Gehäuses erreicht ist. Während dieser Relativbewegung gleiten die Ferritelemente 76 mit ihren jeweiligen Anlagenflächen seitlich der Rinne für die Leitung aneinander entlang.

In Fig. 10 ist zu erkennen, dass das Gehäuseteil 74 angrenzend an den zugeordneten Abschnitt der Durchgangsöffnung 78 zwei U-förmige Bügel 60 aufweist, die eine Klemmwirkung auf eine eingelegte Leitung ausüben. Die zwei identisch ausgebildeten Kulissenführungen 80 sind in den in Fig. 10 hinteren Abschnitten der Seitenwände des zweiten Gehäuseteils 74 vorgesehen, wobei von der in Fig. 10 links angeordneten Kulissenführung 80 lediglich ein Beginn zu erkennen ist. Gegenüberliegend sind in dem in Fig. 10 vorderen Bereich des zweiten Gehäuseteils 74 die Kulissensteine 84 angeordnet, die jeweils mittels Federarmen 86 mit der jeweiligen Seitenwand des zweiten Gehäuseteils 74 verbunden sind. Die Federarme 86 sind beispielsweise einstückig mit dem zweiten Gehäuseteil 74 mittels Spritzguss hergestellt und können dadurch nur begrenzt federn. Die Federwirkung der Federarme 86 rührt von der Elastizität des Materials her, aus dem die Federarme 86 und auch das übrige Gehäuseteil 75 hergestellt sind, beispielsweise aus Kunststoff. Im Rahmen der Erfindung können die Federarme 86 auch starr ausgebildet werden.

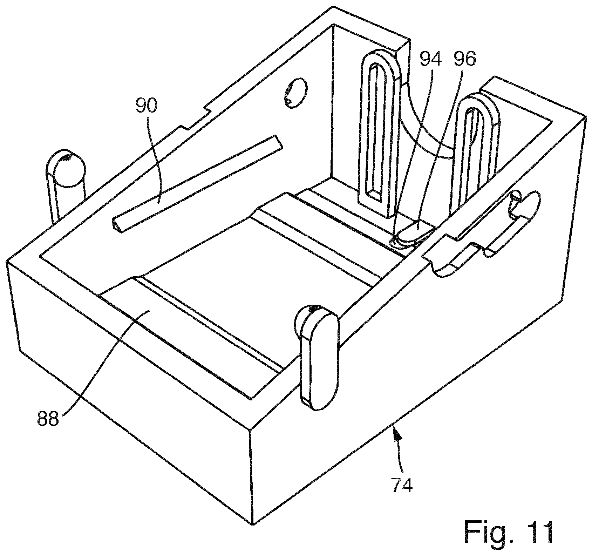

Fig. 11 zeigt das zweite Gehäuseteil 74 der Fig. 10 ohne das Ferritelement 76. Dadurch ist eine Blattfeder 88 am Boden des zweiten Gehäuseteils 74 zu erkennen, die, wie bereits erläutert wurde, das Ferritelement 76 vom zweiten Gehäuseteil 74 weg in Richtung auf das gegenüberliegende Ferritelement im ersten Gehäuseteil 72 drückt.

Um zu verhindern, dass mittels der Wirkung der Blattfeder 88 das Ferritelement 76 zu weit von dem zweiten Gehäuseteil 74 weggedrückt wird und um auch zu verhindern, dass beim Umdrehen des zweiten Gehäuseteils 74 das Ferritelement 76 aus dem zweiten Gehäuseteil 74 herausfällt, sind die Innenseiten der Seitenwände des zweiten Gehäuseteils 74 mit Rastleisten 90 versehen, die Haltevorsprünge bilden und die wenigstens abschnittsweise in seitliche Längsnuten 92 des Ferritelements 76 eingreifen können, siehe Fig. 10. Die Rastleisten 90 verhindern dadurch, dass das Ferritelement 76 über eine definierte Position vom Boden des zweiten Gehäuseteils 74 weggedrückt wird. Die Blattfeder 88 hält das Ferritelement 76 in dieser definierten Position, indem es das Ferritelement 76 gegen die Unterseite der Rastleisten 90 drückt.

Die Blattfeder 88 weist an ihren Stirnseiten jeweils eine Ausnehmung 94 auf, die in einen passenden Vorsprung 96 am Boden des zweiten Gehäuseteils 74 eingreift. In dem in Fig. 11 dargestellten entspannten Zustand der Blattfeder 88 greift der Vorsprung 96 nur abschnittsweise in die Ausnehmung 94 an der Blattfeder 88 ein. Im geschlossenen Zustand des Gehäuses ist die Blattfeder 88 dann komprimiert und der Vorsprung 96 ragt dann ein Stück weiter in die Ausnehmung 94 hinein. Mittels der Vorsprünge 96 am Gehäuse und der Ausnehmungen 94 an der Blattfeder 88 kann eine exakt definierte Montageposition der Blattfeder 88 erzielt werden. Die Vorsprünge 96 und die Ausnehmungen 94 können beispielsweise auch so ausgebildet sein, dass die Blattfeder in die Vorsprünge 96 einrastet und dadurch während der Montage der Einrichtung 70 unverlierbar im zweiten Gehäuseteil 74 gehalten ist. Wie erwähnt sind die beiden Gehäuseteile 72, 74 identisch zueinander ausgebildet, so dass die bezüglich des zweiten Gehäuseteils 74 gemachten Erläuterungen auch für das erste Gehäuseteil 72 gelten.

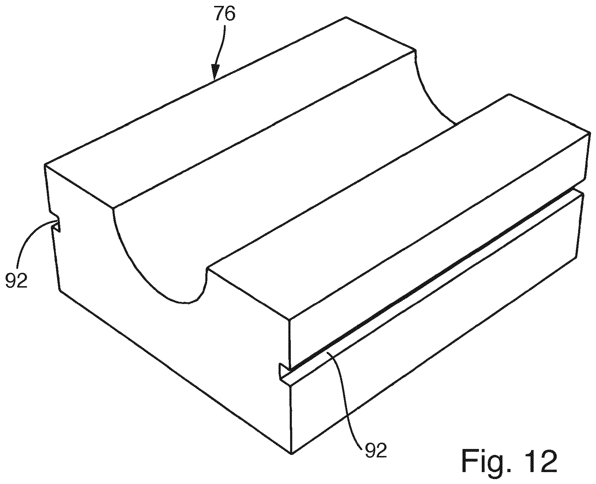

Fig. 12 zeigt das Ferritelement 76 in einer Ansicht von schräg vorne. In dieser Ansicht gut zu erkennen sind die nutförmigen Ausnehmungen 92 in gegenüberliegenden Seitenwänden des Ferritelements 76, in die dann, wie erläutert, die Rastleisten 90 des zweiten Gehäuseteils 74 eingreifen, um das Ferritelement 76 sicher in dem zweiten Gehäuseteil 74 zu halten und dennoch eine Federbewegung entgegen der Wirkung der Blattfeder 88 zu ermöglichen, wenn das erste Gehäuseteil 72 relativ zu dem zweiten Gehäuseteil 74 bewegt wird, um den geschlossenen Zustand des Gehäuses zu erreichen.

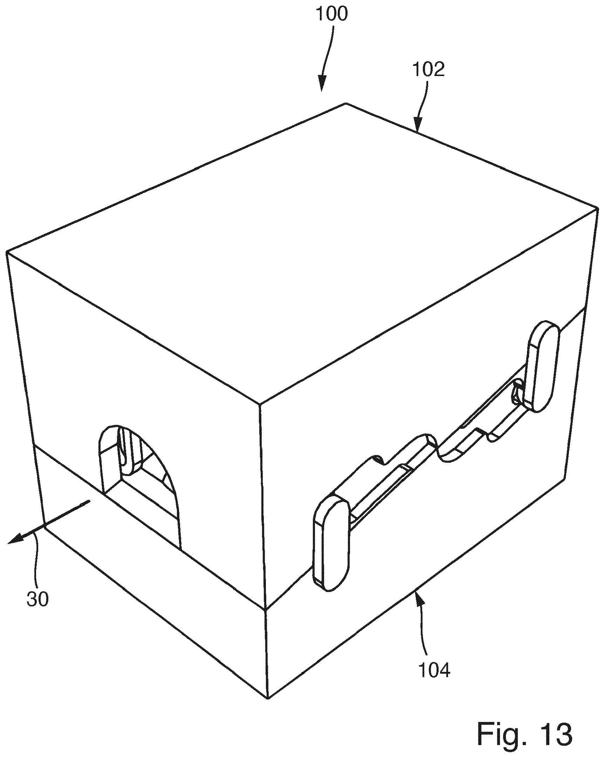

Die Darstellung der Fig. 13 zeigt eine weitere erfindungsgemäße Einrichtung 100, wobei die Einrichtung 100 sehr ähnlich zu der Einrichtung 70 der Fig. 9 bis 12 aufgebaut ist und im Folgenden lediglich die Unterschiede zu der Einrichtung 70 erläutert werden.

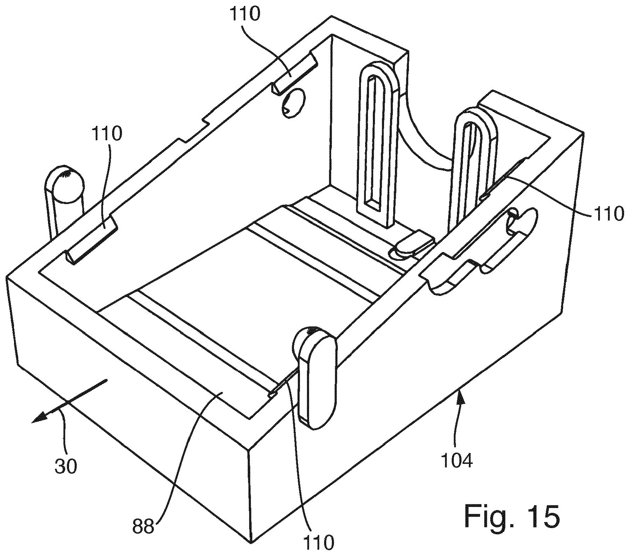

Die Einrichtung 100 weist ein Gehäuse mit einem ersten Gehäuseteil 102 und einem zweiten Gehäuseteil 104 auf. Die Gehäuseteile 102, 104 unterscheiden sich von den Gehäuseteilen 72, 74 der Einrichtung 70 lediglich dadurch, dass in Fig. 15 erkennbaren Rastleisten 110 nicht parallel zur Durchgangsrichtung 30, sondern schräg zur Durchgangsrichtung 30 angeordnet sind. Im Übrigen sind die Gehäuseteile 102, 104 identisch zu den Gehäuseteilen 72, 74 ausgebildet.

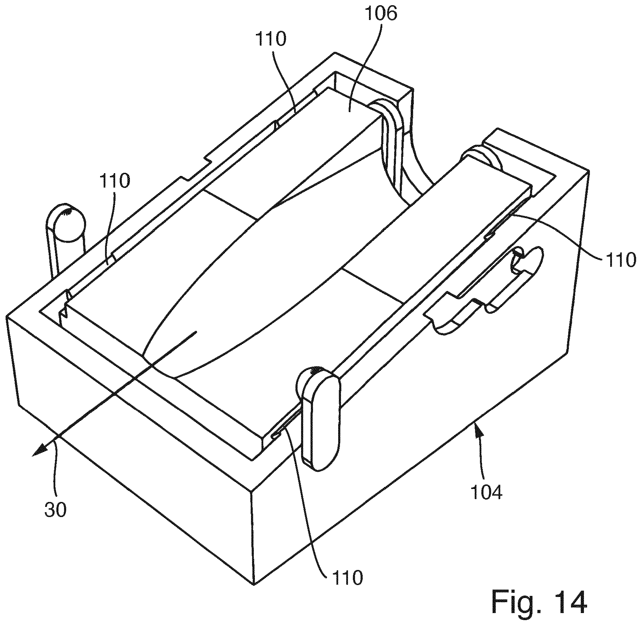

Die unterschiedliche Anordnung der Rastleisten 110 ist, siehe Fig. 14, an die unterschiedliche Form der Ferritelemente 106, siehe Fig. 13, angepasst. Die Ferritelemente 106 weisen schräg zur Durchgangsrichtung 30 angeordnete Anlageflächen auf. Dadurch verringert die rinnenförmige Ausnehmung der Ferritelemente 106, in die eine oder mehrere Leitungen eingelegt werden können, ihre Tiefe zu einer Seite des Ferritelements 106 hin. Werden zwei Ferritelemente 106 aufeinandergelegt, entsteht wieder ein etwa zylindrischer und in radialer Richtung geschlossener Durchgang für wenigstens eine Leitung. Das Ferritelement 106 ist, siehe Fig. 14, an seinen oberen Seitenkanten mit jeweils einem Absatz versehen, der ebenfalls schräg zur Durchgangsrichtung 30 verläuft. An diesem Absatz greifen die Rastleisten 110 an, um zu verhindern, dass das Ferritelement 106 in Fig. 14 nach oben aus dem zweiten Gehäuseteil 104 herausbewegt werden kann. Gegen die Rastleisten 110 wird das Ferritelement 106 mittels der Blattfeder 88 am Boden des zweiten Gehäuseteils 104 vorgespannt, siehe Fig. 15.

Fig. 15 zeigt das zweite Gehäuseteil 104, wobei beide Ferritelemente 106 dargestellt sind. Es ist in dieser Darstellung gut zu erkennen, dass die beiden Ferritelemente 106 einen im Wesentlichen zylindrischen Durchgang für wenigstens eine Leitung bilden. Bei der Relativbewegung der beiden Gehäuseteile 102, 104 vom geöffneten Zustand in den geschlossenen Zustand des Gehäuses bilden nicht nur die Oberseiten der Gehäuseteile 102, 104, sondern auch die Anlageflächen der Ferritelemente 106 eine Anschlagfläche, die das Ende der Relativbewegung und den geschlossenen Zustand des Gehäuses definiert.

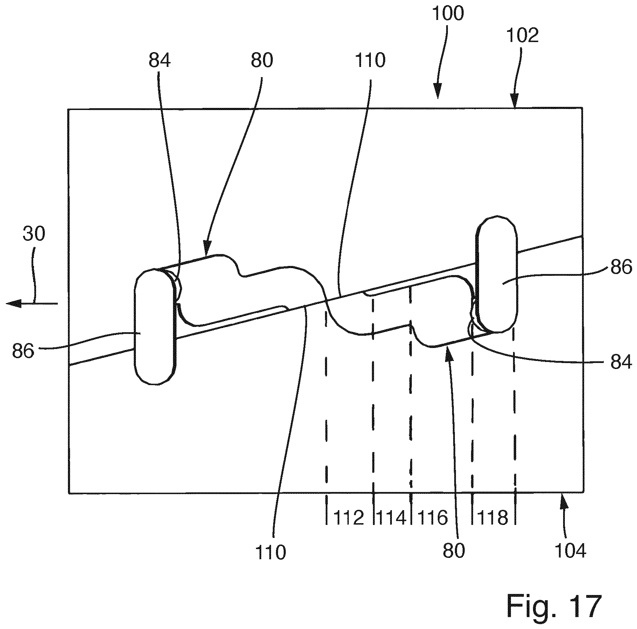

Die Darstellung der Fig. 17 zeigt die Einrichtung 100 der Fig. 13 in einer Seitenansicht. Anhand der Fig. 17 soll die Ausbildung und die Funktion der Kulissenführungen 80 der Einrichtungen 70 und 100 erläutert werden.

Jede der Kulissenführungen 80 weist eine Einführöffnung 110 auf, die gleichzeitig den Beginn der Kulissenführung 80 definiert. In diese Einführöffnung 110 wird beim Zusammenschieben der beiden Gehäuseteile 72, 74, 102, 104 ein Kulissenstein 84 des jeweils anderen Gehäuseteils eingeführt. Der Kulissenstein 84, der mit dem Arm 86 mit dem in Fig. 17 oberen Gehäuseteil 102 verbunden ist, wird infolgedessen von oben in die Einführöffnung 110 der Kulissenführung 80 in der Seite des in Fig. 17 unteren Gehäuseteils 104 eingeführt. Gleichzeitig wird der Kulissenstein 84, der über den Arm 86 mit der Seite des zweiten Gehäuseteils 104 verbunden ist, das in Fig. 17 unten angeordnet ist, von unten in die Einführöffnung 110 der Kulissenführung 80 des in Fig. 17 oberen Gehäuseteils 102 eingeführt.

Im Anschluss an die Einführöffnung 110 weist jede der Kulissenführungen 80 dann einen kreisbogenförmig verlaufenden Abschnitt 112 auf. Der kreisbogenförmige Abschnitt 112 geht in einen geradlinig und parallel zur Oberseite des jeweiligen Gehäuseteils 102, 104 verlaufenden Abschnitt 114 über. In den Abschnitten 112, 114 ist eine Höhe der Kulissenführung 80 in etwa so groß wie eine Höhe des Kulissensteins 84. Der Kulissenstein wird also in den Abschnitten 112, 114 annähernd spielfrei oder nur mit geringem Spiel in der Kulissenführung 80 geführt.

In einem weiteren Abschnitt 116, der sich an den Abschnitt 114 anschließt, verläuft die Kulissenführung 80 weiter parallel zur Oberseite des jeweiligen Gehäuseteils 104, nimmt aber in ihrer Höhe zu. Dies ermöglicht es, dass der Kulissenstein 84 des jeweils anderen Gehäuseteils sich auch in Höhenrichtung innerhalb der Kulissenführung 80 im Abschnitt 116 bewegen kann. Dies kann erforderlich sein, um die Ferritelemente 76, 106 aufeinander aufzusetzen und gegebenenfalls gegen die Wirkung der Federeinrichtung in Richtung auf das jeweils zugeordnete Gehäuseteil zu drücken.

Auf den Abschnitt 116 folgt ein Endabschnitt 118 der Kulissenführung 80. In diesem Endabschnitt 118 ist die Höhe der Kulissenführung 80 gegenüber dem Abschnitt 116 wieder deutlich verringert und entspricht im Wesentlichen der Höhe des Kulissensteins 84. Durch den Endabschnitt 118 bzw. den Übergang von dem Abschnitt 116 zum Endabschnitt 118 wird der Kulissenstein 84 in Höhenrichtung dadurch exakt positioniert und in den Bereich vor einer Ausnehmung 120 in der Seitenwand des unteren Gehäuseteils 74, 104 geführt. Diese Ausnehmung 120 ist als Rastausnehmung passend zur Form des Kulissensteins 84 ausgebildet. Sobald der Kulissenstein 84 somit in den Endabschnitt 118 gelangt, kann er in die Ausnehmung 120 einschnappen und dadurch die beiden Gehäuseteile 72, 74, 102, 104 sicher im geschlossenen Zustand des Gehäuses halten, der in Fig. 17 dargestellt ist.

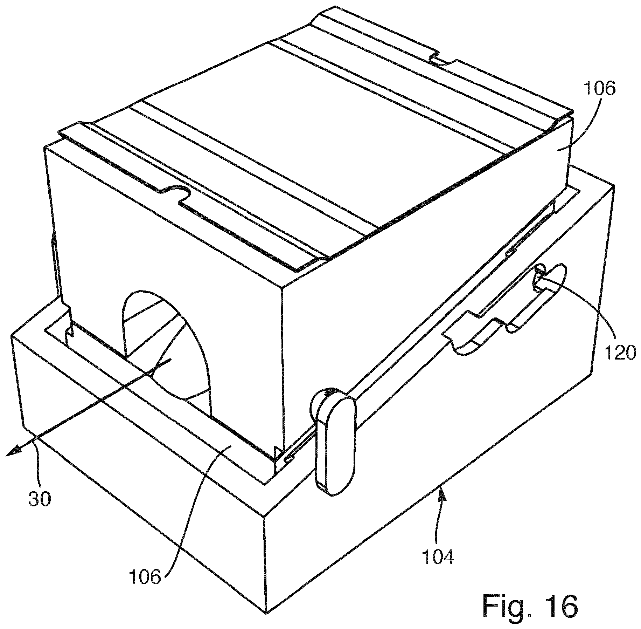

In Fig. 16 ist die Ausnehmung 120 als Durchgangsöffnung in der Seitenwand des zweiten Gehäuseteils 104 dargestellt. Im Rahmen der Erfindung kann die Ausnehmung 120 aber auch lediglich als Vertiefung in der Kulissenführung 80 ausgebildet sein. Es ist im Rahmen der Erfindung ebenfalls möglich, anstelle der Ausnehmung 120 einen Vorsprung vorzusehen, der dann beispielsweise in eine passende Ausnehmung im Kulissenstein 84 einschnappt.

Mittels der Kulissenführung 80 und den Kulissensteinen 84 können die beiden Gehäuseteile 72, 74, 102, 104 in einer Relativbewegung zueinander, deren Hauptkomponente parallel zur Durchgangsrichtung 30 verläuft, aneinander geführt und zuverlässig in eine Endposition gebracht werden. In der Endposition greifen die Kulissensteine 84 in die Ausnehmungen 120 ein und verriegeln dadurch gleichzeitig die beiden Gehäuseteile 72, 74, 102, 104 im geschlossenen Zustand des Gehäuses aneinander.

Im Rahmen der Erfindung können separate Rastmittel vorgesehen sein, die am Ende der Relativbewegung die beiden Gehäuseteile im geschlossenen Zustand des Gehäuses aneinander verriegeln. Bei den dargestellten Ausführungsformen der Einrichtungen 70, 100 übernehmen die Kulissensteine 84 und die Kulissenführungen 80 gleichzeitig die Funktion der Verriegelungseinrichtung. Dies ist aber nicht zwingend im Rahmen der Erfindung.

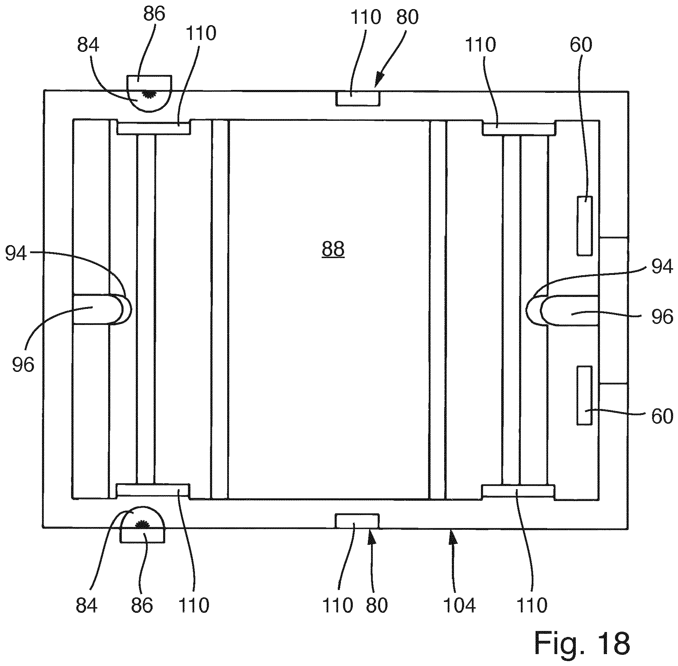

Die Darstellung der Fig. 18 zeigt das zweite Gehäuseteil 104 der Einrichtung 100 der Fig. 13 in einer Ansicht von oben. In dieser Ansicht gut zu erkennen ist die Blattfeder 88 im entspannten Zustand, die mit ihren Ausnehmungen 94, die einander gegenüberliegen, abschnittsweise an den Vorsprüngen 96 am Boden des zweiten Gehäuseteils 104 angreift. Ebenfalls zu erkennen sind in dieser Ansicht die U-förmigen Bügel 60 zum Klemmen der Leitung und die Rastleisten 110 zum Festhalten des Ferritelements 106 gegen die Vorspannung der Blattfeder 88.

Zu erkennen sind auch die Arme 86 und die an den Enden der Arme angeordneten Kulissensteine 84. Die Kulissensteine 84 am Gehäuseteil 104 sind einander gegenüberliegend angeordnet. Ebenfalls zu erkennen sind jeweils die Einführöffnungen 110 der beiden Kulissenführungen 80 in den gegenüberliegenden Seitenwänden des zweiten Gehäuseteils 104.

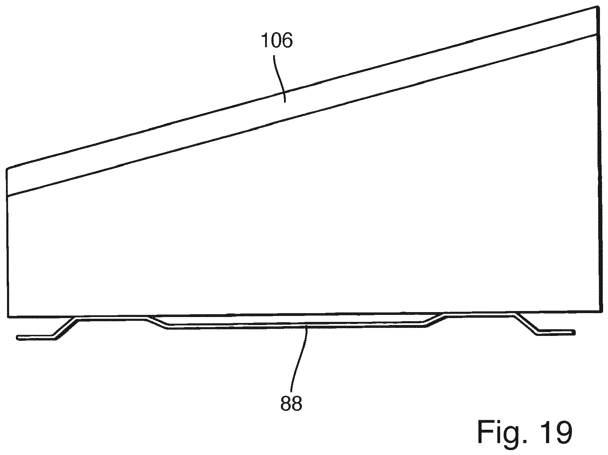

Die Darstellung der Fig. 19 zeigt das Ferritelement 106, siehe beispielsweise Fig. 14, mit der unterhalb des Ferritelements angeordneten Blattfeder 88. Fig. 18 zeigt die Blattfeder 88 im entspannten Zustand.

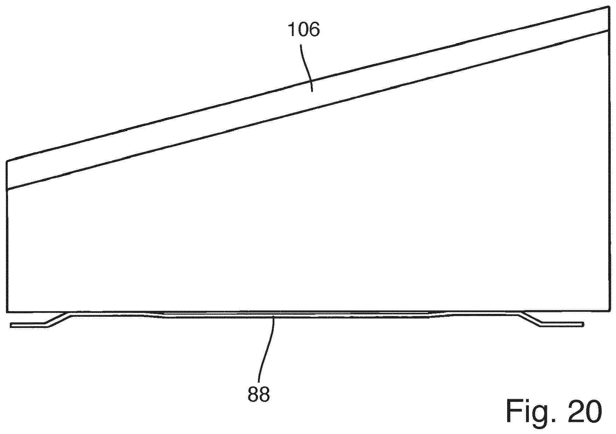

Fig. 20 zeigt das Ferritelement 106 und die Blattfeder 88 der Fig. 19 in dem Zustand, in dem das Ferritelement 106 gegen die Blattfeder 88 gedrückt wird. Die Blattfeder 88 befindet sich dadurch im komprimierten Zustand. Dieser Zustand der Blattfeder 88 wird dann erreicht, wenn sich das Gehäuse im geschlossenen Zustand befindet. Die Blattfeder 88 sorgt dann für eine Vorspannung des Ferritelements 106 in Richtung auf das gegenüberliegende Ferritelement 106 im gegenüberliegenden Gehäuseteil. Das Ferritelement 106 im gegenüberliegenden Gehäuseteil ist ebenfalls mit einer identischen Blattfeder 88 vorgespannt. Dadurch wird sichergestellt, dass zwischen den beiden Ferritelementen 106 kein Spalt bzw. lediglich ein mikroskopischer Spalt vorhanden ist. Dadurch können sehr gute elektrische und magnetische Eigenschaften der Ferritelemente 106 erzielt werden und mit der erfindungsgemäßen Einrichtung kann elektrisches Rauschen auf Leitungen weitgehend absorbiert werden.

Die anhand der Fig. 19 und 20 gemachten Erläuterungen gelten auch für die Ferritelemente 46, 76, deren Oberseite parallel zur Unterseite verläuft. Auch dort sorgen die Blattfedern 88 oder andere, geeignete Federeinrichtungen für eine Vorspannung der Ferritelemente gegeneinander und für eine spaltfreie Anordnung der Ferritelemente im geschlossenen Zustand des Gehäuses.

## Patentansprüche

1. Einrichtung (70, 100) zum Absorbieren von elektrischem Rauschen auf Leitungen, mit einem zwei Gehäuseteile (72, 74, 102, 104) aufweisenden Gehäuse, wobei jedes Gehäuseteil zum Aufnehmen je eines Elements aus einem Rauschen absorbierenden Material vorgesehen ist, wobei das Gehäuse im geschlossenen Zustand in zwei gegenüberliegenden Stirnwänden je eine Durchgangsöffnung (78) für eine oder mehrere Leitungen aufweist, wobei die Elemente (76, 106) in den Gehäuseteilen im geschlossenen Zustand des Gehäuses einen Durchgang für eine oder mehrere Leitungen bilden, wobei die Durchgangsöffnungen (78) im Gehäuse und der mittels der Elemente (76, 106) gebildete Durchgang eine Durchgangsrichtung (30) für die wenigstens eine Leitung definieren, wobei eine Verriegelungseinrichtung zum Verriegeln der Gehäuseteile im geschlossenen Zustand des Gehäuses vorgesehen ist, wobei die Gehäuseteile so ausgebildet sind, dass die Gehäuseteile mittels einer Relativbewegung der Gehäuseteile zueinander, wobei eine Hauptkomponente der Relativbewegung parallel zu der Durchgangsrichtung (30) verläuft, in den geschlossenen Zustand des Gehäuses bewegt und in dem geschlossenen Zustand aneinander verriegelt werden können, **dadurch gekennzeichnet, dass** das Gehäuse mittels der Gehäuseteile (72, 74; 102, 104) schräg zu der Durchgangsrichtung (30) geteilt ist.

2. Einrichtung nach Anspruch 1, **dadurch gekennzeichnet, dass** die beiden Gehäuseteile (72, 74, 102, 104) identisch ausgebildet sind.

3. Einrichtung nach Anspruch 1 oder 2, **dadurch gekennzeichnet, dass** die Elemente (106) im geschlossenen Zustand des Gehäuses schräg zu der Durchgangsausrichtung geteilt sind.

4. Einrichtung nach wenigstens einem der vorstehenden Ansprüche, **dadurch gekennzeichnet, dass** die Gehäuseteile (72, 74, 102, 104) mit einer Schiebeführung versehen sind.

5. Einrichtung nach Anspruch 4, **dadurch gekennzeichnet, dass** die Schiebeführung als Kulissenführung (80) ausgebildet ist.

6. Einrichtung nach Anspruch 4, **dadurch gekennzeichnet, dass** die Schiebeführung mittels Führungsleisten als Linearführung ausgebildet ist

7. Einrichtung nach wenigstens einem der vorstehenden Ansprüche, **dadurch gekennzeichnet, dass** die Verriegelungseinrichtung Rastmittel mit Rastvorsprüngen und Rastausnehmungen aufweist.

8. Einrichtung nach Anspruch 7 in Abhängigkeit von einem der Ansprüche 4 bis 6, **dadurch gekennzeichnet, dass** die Rastmittel getrennt von der Schiebeführung angeordnet sind.

9. Einrichtung nach Anspruch 7 oder 8, **dadurch gekennzeichnet, dass** die Rastmittel federnde Rastarme aufweisen.

10. Einrichtung nach Anspruch 7 in Abhängigkeit von einem der Ansprüche 4 bis 6, **dadurch gekennzeichnet, dass** die Rastmittel an der Schiebeführung angeordnet sind.

11. Einrichtung nach Anspruch 10, **dadurch gekennzeichnet, dass** die Rastmittel wenigstens eine Rastausnehmung in der Schiebeführung aufweisen.

12. Einrichtung nach wenigstens einem der vorstehenden Ansprüche, **dadurch gekennzeichnet, dass** wenigstens eines der Elemente mit wenigstens einer Anlaufschräge versehen ist, wobei die Anlaufschräge so ausgebildet ist, dass sie bei der Relativbewegung vom geöffneten Zustand in den geschlossenen Zustand des Gehäuses auf das jeweils andere Element aufläuft.

13. Einrichtung nach wenigstens einem der vorstehenden Ansprüche, **dadurch gekennzeichnet, dass** zwischen jeweils einem Element (76, 106) und dem zugeordneten Gehäuseteil eine Federeinrichtung (88) vorgesehen ist, um das Element (76, 106) bei geschlossenem Gehäuse in Richtung auf das Element (76,106) im anderen Gehäuseteil vorzuspannen.

14. Einrichtung nach Anspruch 13, **dadurch gekennzeichnet, dass** die Federeinrichtung eine Blattfeder (88) aufweist.

15. Verfahren zum Anordnen einer Einrichtung nach wenigstens einem der vorstehenden Ansprüche auf wenigstens eine elektrische Leitung, **gekennzeichnet durch** Bewegen der beiden Gehäuseteile des Gehäuses der Einrichtung mittels einer Relativbewegung der beiden Gehäuseteile zueinander in den geschlossenen Zustand des Gehäuses.

## Claims

1. Device (70, 100) for absorbing electrical noise on lines, having a housing which has two housing parts (72, 74, 102, 104), wherein each housing part is provided for receiving in each case one element composed of a noise-absorbing material, wherein, in the closed state, the housing has in two oppositely situated end walls in each case one passage opening (78) for one or more lines, wherein, in the housing parts, the elements (76, 106), in the closed state of the housing, form a passage for one or more lines, wherein the passage openings (78) in the housing and the passage formed by means of the elements (76, 106) define a passage direction (30) for the at least one line, wherein a locking device is provided for locking the housing parts in the closed state of the housing, wherein the housing parts are designed in such a way that the housing parts, by means of a relative movement of the housing parts with respect to one another, wherein a main component of the relative movement is parallel to the passage direction (30), can be moved into the closed state of the housing and, in the closed state, can be locked to one another, **characterized in that** the housing is divided obliquely in relation to the passage opening (30) by means of the housing parts (72, 74; 102, 104).

2. Device according to Claim 1, **characterized in that** the two housing parts (72, 74, 102, 104) are of identical design.

3. Device according to Claim 1 or 2, **characterized in that**, in the closed state of the housing, the elements (106) are divided obliquely with respect to the passage orientation.

4. Device according to at least one of the preceding claims, **characterized in that** the housing parts (72, 74, 102, 104) are provided with a sliding guide.

5. Device according to Claim 4, **characterized in that** the sliding guide is designed as a slotted guide (80).

6. Device according to Claim 4, **characterized in that** the sliding guide is designed as a linear guide by means of guide rails.

7. Device according to at least one of the preceding claims, **characterized in that** the locking device has latching means with latching projections and with latching cutouts.

8. Device according to Claim 7 where dependent on one of Claims 4 to 6, **characterized in that** the latching means are arranged separately from the sliding guide.

9. Device according to Claim 7 or 8, **characterized in that** the latching means have resilient latching arms.

10. Device according to Claim 7 where dependent on one of Claims 4 to 6, **characterized in that** the latching means are arranged on the sliding guide.

11. Device according to Claim 10, **characterized in that** the latching means have at least one latching cutout in the sliding guide.

12. Device according to at least one of the preceding claims, **characterized in that** at least one of the elements is provided with at least one run-on bevel, wherein the run-on bevel is formed in such a way that, during the relative movement from the open state into the closed state of the housing, it runs onto the in each case other element.

13. Device according to at least one of the preceding claims, **characterized in that**, between in each case one element (76, 106) and the associated housing part, there is provided a spring device (88) for preloading the element (76, 106) in the direction of the element (76, 106) in the other housing part with the housing closed.

14. Device according to Claim 13, **characterized in that** the spring device has a leaf spring (88).

15. Method for arranging a device according to at least one of the preceding claims on at least one electrical line, **characterized by** moving the two housing parts of the housing of the device into the closed state of the housing by means of a relative movement of the two housing parts with respect to one another.

## Revendications

1. Dispositif (70, 100) pour absorber le bruit électrique sur des lignes, avec un boîtier présentant deux parties de boîtier (72, 74, 102, 104), chaque partie de boîtier étant prévue pour recevoir respectivement un élément en un matériau absorbant le bruit, le boîtier, à l'état fermé, présentant dans deux parois d'extrémité opposées respectivement une ouverture de passage (78) pour une ou plusieurs lignes, les éléments (76, 106) dans les parties de boîtier formant, à l'état fermé du boîtier, un passage pour une ou plusieurs lignes, les ouvertures de passage (78) dans le boîtier et le passage formé au moyen des éléments (76, 106) définissant une direction de passage (30) pour l'au moins une ligne, un dispositif de verrouillage étant prévu pour verrouiller les parties de boîtier à l'état fermé du boîtier, les parties de boîtier étant configurées de telle sorte que les parties de boîtier peuvent être déplacées à l'état fermé du boîtier au moyen d'un mouvement relatif des parties de boîtier l'une par rapport à l'autre, une composante principale du mouvement relatif étant parallèle à la direction de passage (30), et verrouillées l'une à l'autre à l'état fermé, **caractérisé en ce que** le boîtier peut être divisé au moyen des parties de boîtier (72, 74 ; 102, 104) obliquement par rapport à la direction de passage (30).

2. Dispositif selon la revendication 1, **caractérisé en ce que** les deux parties du boîtier (72, 74, 102, 104) sont configurées sous forme identique.

3. Dispositif selon la revendication 1 ou 2, **caractérisé en ce que** les éléments (106) sont divisés obliquement par rapport à l'orientation du passage à l'état fermé du boîtier.

4. Dispositif selon au moins l'une quelconque des revendications précédentes, **caractérisé en ce que** les parties de boîtier (72, 74, 102, 104) sont pourvues d'un guide coulissant.

5. Dispositif selon la revendication 4, **caractérisé en ce que** le guide coulissant est configuré sous forme de guide à coulisse (80).

6. Dispositif selon la revendication 4, **caractérisé en ce que** le guide coulissant est configuré sous forme de guide linéaire au moyen de barres de guidage.

7. Dispositif selon au moins l'une quelconque des revendications précédentes, **caractérisé en ce que** le dispositif de verrouillage présente des moyens d'encliquetage avec des saillies d'encliquetage et des évidements d'encliquetage.

8. Dispositif selon la revendication 7 dépendant de l'une quelconque des revendications 4 à 6, **caractérisé en ce que** les moyens d'encliquetage sont agencés séparément du guide coulissant.

9. Dispositif selon la revendication 7 ou 8, **caractérisé en ce que** les moyens d'encliquetage présentent des bras d'encliquetage élastiques.

10. Dispositif selon la revendication 7 dépendant de l'une quelconque des revendications 4 à 6, **caractérisé en ce que** les moyens d'encliquetage sont agencés sur le guide coulissant.

11. Dispositif selon la revendication 10, **caractérisé en ce que** les moyens d'encliquetage présentent au moins un évidement d'encliquetage dans le guide coulissant.

12. Dispositif selon au moins l'une quelconque des revendications précédentes, **caractérisé en ce qu'**au moins l'un des éléments est pourvu d'au moins un biseau d'attaque, le biseau d'attaque étant configuré de telle sorte qu'il monte sur l'autre élément respectif lors du mouvement relatif de l'état ouvert à l'état fermé du boîtier.

13. Dispositif selon au moins l'une quelconque des revendications précédentes, **caractérisé en ce qu'**un dispositif à ressort (88) est prévu entre un élément (76, 106) respectif et la partie de boîtier associée, afin de précontraindre l'élément (76, 106) en direction de l'élément (76, 106) dans l'autre partie de boîtier lorsque le boîtier est fermé.

14. Dispositif selon la revendication 13, **caractérisé en ce que** le dispositif à ressort présente un ressort à lame (88).

15. Procédé d'agencement d'un dispositif selon au moins l'une quelconque des revendications précédentes sur au moins une ligne électrique, **caractérisé par** le déplacement des deux parties de boîtier du boîtier du dispositif au moyen d'un mouvement relatif des deux parties de boîtier l'une par rapport à l'autre à l'état fermé du boîtier.
